# EUROPÄISCHE PATENTSCHRIFT

(11) **EP 3 763 177 B1**
(45) Veröffentlichungstag und Bekanntmachung des Hinweises auf die Patenterteilung: **07.06.2023**
(21) Anmeldenummer: 19705928.0
(22) Anmeldetag: 15.02.2019
(51) Int. Cl.: H05K 7/20, H05K 5/02

(54) **ELEKTROGERÄTEANORDNUNG, AUFWEISEND EIN AN EINEM TRAGELEMENT, INSBESONDERE EINER WAND, BEFESTIGBARES ELEKTROGERÄT**
ELECTRICAL APPLIANCE ARRANGEMENT HAVING AN ELECTRICAL APPLIANCE WHICH CAN BE FASTENED TO A SUPPORT ELEMENT, IN PARTICULAR A WALL
AGENCEMENT D'APPAREIL ÉLECTRIQUE PRÉSENTANT UN APPAREIL ÉLECTRIQUE POUVANT ÊTRE FIXÉ À UN ÉLÉMENT DE SUPPORT, EN PARTICULIER UNE PAROI

(30) Priorität: 05.03.2018 DE 102018001687
(43) Veröffentlichungstag der Anmeldung: 13.01.2021
(73) Patentinhaber: SEW-EURODRIVE GmbH & Co. KG, 76646 Bruchsal (DE)
(72) Erfinder: SCHÖRNER, Martin, 76646 Bruchsal (DE); NIKOLA, Joachim, 76703 Kraichtal (DE); KOLLAR, Hans, Jürgen, 76646 Bruchsal (DE)
(86) Internationale Anmeldenummer: PCT/EP2019/025044
(87) Internationale Veröffentlichungsnummer: WO 2019/170290

(56) Entgegenhaltungen:
- DE-A1-102015 200 375
- US-A1- 2002 064 028
- US-A1- 2008 130 232
- US-A1- 2010 202 109

## Beschreibung

Die Erfindung betrifft eine **Elektrogeräteanordnung, aufweisend** ein an einem Tragelement, insbesondere einer Wand, befestigbares Elektrogerät.

Es ist allgemein bekannt einen Kühlkörper zur Entwärmung von Wärme erzeugenden Bauteilen vorzusehen.

**Aus der** DE 10 2015 200375 A1 **ist als nächstliegender Stand der Technik eine Elektrogeräteanordnung mit einem Tragelement bekannt, wobei eine Leiterplatte am Kühlkörper befestigt ist und der Kühlkörper am Tragelement befestigt ist.**

**Aus der** US 2002/064028 A1 **ist eine Kühlanordnung für Leistungshalbleiter bekannt.**

**Aus der** US 2008 1130232 A1 **ist eine Wärmesenke bekannt.**

**Aus der** US 2010/202109 A1 **ist ein Frequenzumrichter bekannt.**

Der Erfindung liegt daher die Aufgabe zugrunde, ein Elektrogerät weiterzubilden, wobei eine besonders einfache Herstellung erreichbar sein soll.

Erfindungsgemäß wird die Aufgabe bei der **Elektrogeräteanordnung** nach den in Anspruch 1 angegebenen Merkmalen gelöst.

Wichtige Merkmale der Erfindung bei der **Elektrogeräteanordnung mit** an einem Tragelement, insbesondere Wand, befestigbare**m** Elektrogerät, sind, dass das Elektrogerät einen Kühlkörper, Leiterplatten und ein Gehäuse aufweist,
wobei die Leiterplatten jeweils am Kühlkörper befestigt sind und der Kühlkörper an dem Tragelement befestigbar ist oder befestigt ist,
insbesondere wobei das Gehäuse die Leiterplatten gehäusebildend umgibt und am Kühlkörper befestigt ist.

Von Vorteil ist dabei, dass der Kühlkörper die Leiterplatten und das Gehäuse trägt und somit als zentrales Tragelement des Geräts fungiert. Der Kühlkörper ist an einem Tragelement einer Maschine oder Anlage befestigbar, beispielsweise an einer Wand. Durch die Befestigung an diesem Tragelement sind auch die Leiterplatten und das Gehäuse gehalten. Die Gewichtskraft der jeweiligen Leiterplatte wird also über den Kühlkörper an die Wand abgeleitet. Ebenso wird die Gewichtskraft des Gehäuses über den Kühlkörper an die Wand abgeleitet.

Darüber hinaus weist der Kühlkörper auch einen Anschluss für elektrisch Erde auf und fungiert somit als Ableitung an elektrisch Erde.

Bei einer vorteilhaften Ausgestaltung weist das Elektrogerät ein Leistungsmodul auf, welches pulsweitenmoduliert angesteuerte Halbleiterschalter aufweist,
insbesondere wobei das Leistungsmodul auf der ersten der Leiterplatten angeordnet ist. Von Vorteil ist dabei, dass die mit hohen Strömen und/oder Spannung getaktet betriebenen Bauteile auf der ersten Leiterplatte angeordnet sind, welche somit nur auf einer Seite des Kühlkörpers angeordnet ist. Auf der von der ersten Leiterplatte abgewandten Seite des Kühlkörpers ist somit eine dritte Leiterplatte vorsehbar, welche eine elektronische Schaltung aufweist. Diese elektronische Schaltung ist von Störsignalen der ersten Leiterplatte ungestört betreibbar, da der Kühlkörper aus Metall gefertigt ist, insbesondere aus Aluminium, und somit als Abschirmung fungiert.

Bei einer vorteilhaften Ausgestaltung ist das Leistungsmodul an einer Kontaktfläche des Kühlkörpers mit dem Kühlkörper verbunden, insbesondere zur Wärmeabfuhr. Von Vorteil ist dabei, dass der Kühlkörper den einströmenden Wärmestrom aufspreizt. Somit ist die Spitzentemperatur möglichst niedrig haltbar.

Erfindungsgemäß ist die Kontaktfläche an einer Grundplatte des Kühlkörpers angeordnet. Von Vorteil ist dabei, dass die Kontaktfläche an einem Bereich des Kühlkörpers mit größer Wandstärke angeordnet ist.

Erfindungsgemäß sind am Kühlkörper Kühlrippen an der der Kontaktfläche gegenüberliegenden Seite der Grundplatte ausgeformt. Von Vorteil ist dabei, dass die an der Kontaktfläche eingebrachte Wärme möglichst direkt von der Grundplatte über die Kühlrippen ableitbar ist, an denen ein von einem Lüfter geförderter Luftstrom entlang bewegt wird, wobei der Lüfter am Kühlkörper befestigt ist.

Erfindungsgemäß ist an einer ersten der Kühlrippen ein plattenförmiger, parallel zur Grundplatte angeordneter Tragabschnitt angeformt.

Bei einer vorteilhaften Ausgestaltung ist ein plattenförmiger, senkrecht zur Grundplatte angeordneter Wandabschnitt an der Grundplatte angeformt, wobei die Grundplatte zwischen dem Tragabschnitt und dem Wandabschnitt angeordnet ist, insbesondere wobei das Elektrogerät mittels des Wandabschnitts an der Wand befestigbar und/oder befestigt ist. Von Vorteil ist dabei, dass der Tragabschnitt keine direkte Verlängerung der Grundplatte ist, sondern zwar parallel aber mit Versatz ausgeführt ist. Somit sind neben dem Leistungsmodul, das eine erste Bauhöhe bis zur Kontaktfläche an der Grundplatte einnimmt, weitere Bauteile auf der ersten Leiterplatte bestückbar, die eine zweite Bauhöhe einnehmen dürfen, insbesondere nämlich bis zu dem mittels des Versatzes weiter von der ersten Leiterplatte entfernten Tragabschnitt. Weil also der Versatz derart ist, dass der Tragabschnitt weiter von der ersten Leiterplatte entfernt ist als die Grundplatte von der ersten Leiterplatte, sind im von dem Tragabschnitt überdeckten Bereich der ersten Leiterplatte größere Bauteile auf der dem Tragabschnitt zugewandten Seite der ersten leiterplatte bestückbar als auf dem von der Grundplatte überdeckten Bereich der ersten Leiterplatte.

Bei einer vorteilhaften Ausgestaltung sind Wandabschnitt, Grundplatte, Kühlrippen und Tragabschnitt einstückig, also einteilig, als Kühlkörper ausgebildet,
insbesondere als Aluminiumgussteil. Von Vorteil ist dabei, dass eine stabile Befestigung ermöglicht ist.

Bei einer vorteilhaften Ausgestaltung weist der Tragabschnitt einen Versatz zur Grundplatte auf,
insbesondere also die Ebene des Tragabschnitts zur Ebene der Grundplatte zwar parallel aber beabstandet ist. Von Vorteil ist dabei, dass größere Bauteile auf der ersten leiterplatte im zum Tragabschnitt benachbarten Bereich bestückbar sind als im zur Grundplatte benachbarten Bereich.

**Erfindungsgemäß** ist am Tragabschnitt eine Aufnahmetasche angeordnet, wobei eine Seite der Aufnahmetasche mittels einem Bereich der ersten Kühlrippe gebildet ist,
wobei ein Wärme erzeugendes Bauteil, insbesondere Leistungsbauteil, insbesondere Halbleiterschalter, in der Aufnahmetasche angeordnet ist, wobei zwischen dem Bauteil und der Aufnahmetasche ein elektrisch isolierendes, wärmeleitendes Material angeordnet ist, insbesondere dessen Elastizität größer ist als Aluminium und als das Trägermaterial der ersten der Leiterplatten und dessen spezifische Wärmeleitfähigkeit mindestens ein Zehntel von Aluminium beträgt. Von Vorteil ist dabei, dass das Leistungsbauteil an mehreren Seiten umgeben ist vom Material der Aufnahmetasche, also vom Kühlkörper, und in der Aufnahmetasche spielfrei aufgenommen ist. Somit sind mechanische Schwingungen relativ zwischen Bauteil und Aufnahmetasche verhindert.

Bei einer vorteilhaften Ausgestaltung ist das Leistungsbauteil in eine wärmeleitende Kunststoffhülle, insbesondere Gummitülle, eingeführt und mit dieser in der Aufnahmetasche spielfrei aufgenommen. Von Vorteil ist dabei, dass die Kunststoffhülle elektrisch isolierend wirkt und trotzdem ein gut wärmeleitender Kontakt vom Bauteil zum Kühlkörper erreichbar ist. Insbesondere ist im Kunststoff ein Zusatz von elektrisch isolierenden Partikeln, die aber sehr gute Wärmeleiter sind, ausgeführt. Besonders geeignete sind hier Keramik-Partikel, insbesondere mit einer Korngröße von weniger als 10 Mikrometern.

Bei einer vorteilhaften Ausgestaltung ist am Wandabschnitt des Kühlkörpers ein Anschluss für PE-Verbindung, insbesondere also Verbindung mit elektrisch Erde, angeordnet. Von Vorteil ist dabei, dass der Kühlkörper nicht nur zur Entwärmung und zum Halten des Geräts, sondern auch zur elektrischen Erdung oder zur elektrischen Erdableitung verwendbar ist. besonders vorteilhaft ist dies dann ausführbar, wenn die mit dem Wandabschnitt verbundene Wand beziehungsweise ein Tragteil selbst aus Metall ausgeführt ist und elektrisch geerdet ist. Wenn die Wand also die Rückwand eines Schaltschranks oder ein Tragteil einer Maschine ist, fungiert der Kühlkörper zusammen mit der Wand beziehungsweise dem Tragteil als Wärmeableitung.

Bei einer vorteilhaften Ausgestaltung sind am Tragabschnitt beidseitig Domabschnitte und an der den Kühlkörpern gegenüberliegenden Seite der Grundplatte ebenfalls Domabschnitte ausgeformt,
wobei eine erste Leiterplatte an ersten Domabschnitten, insbesondere mittels Schrauben, wobei die ersten Domabschnitte sich von dem Tragabschnitt aus erheben, und an zweiten Domabschnitten befestigt ist, wobei die zweiten Domabschnitte sich von der den Kühlrippen gegenüberliegenden Seite der Grundplatte aus erheben,
wobei eine dritte Leiterplatte an dritten Domabschnitten, insbesondere mittels Schrauben, befestigt ist, wobei die dritten Domabschnitte sich von der der ersten Leiterplatte gegenüberliegenden Seite des Tragabschnitts aus erheben,
wobei eine zweite Leiterplatte an vierten Domabschnitten befestigt ist, wobei einer der vierten Domabschnitte sich von einem der ersten Domabschnitte aus erhebt, also angeformt ist an den ersten Domabschnitt,
wobei die erste Leiterplatte parallel zur dritten Leiterplatte ausgerichtet ist,
wobei die erste Leiterplatte zur dritten Leiterplatte beabstandet ist,
insbesondere wobei der Tragabschnitt zwischen der ersten und dritten Leiterplatte angeordnet ist,
wobei die zweite Leiterplatte senkrecht zur ersten und auch senkrecht zur dritten Leiterplatte angeordnet ist. Von Vorteil ist dabei, dass die Leiterplatte über Domabschnitte an dem Kühlkörper haltbar ist.

Bei einer vorteilhaften Ausgestaltung ist zur Befestigung der jeweiligen Leiterplatte am jeweiligen Domabschnitt im dem jeweiligen Domabschnitt eine Gewindebohrung angeordnet,
wobei ein Schraubenkopf einer jeweiligen in die jeweilige Gewindebohrung eingeschraubten Schraube die jeweilige Leiterplatte gegen den jeweiligen Domabschnitt drückt. Von Vorteil ist dabei, dass eine einfache Befestigungsmethode ausführbar ist. Wichtig ist dabei, dass die Gewindebohrungen des vierten und ersten Domabschnitts voneinander beabstandet sind oder zumindest die jeweils darin eingeschraubten Schrauben sich nicht berühren, obwohl die Gewindebohrungen sich senkrecht zueinander ausgerichtet sind und ihre Bohrungsachsen sich schneiden.

Bei einer vorteilhaften Ausgestaltung weist der Tragabschnitt an seiner von der ersten Leiterplatte abgewandten Seite Verstärkungsrippen auf,
insbesondere gitterförmig ausgeführte Verstärkungsrippen. Von Vorteil ist dabei, dass erhöhte Stabilität erreichbar ist und somit die Haltefunktion aber auch die Funktion der Wärmeaufspreizung verbessert ausführbar ist.

Bei einer vorteilhaften Ausgestaltung weist jede der Kühlrippen Verdickungen, insbesondere regelmäßig voneinander beabstandete Verdickungen, auf. Von Vorteil ist dabei, dass die Stabilität der Kühlrippen und deren Funktion der Wärmeaufspreizung verbessert ausführbar ist.

Bei einer vorteilhaften Ausgestaltung ist eine dritte Leiterplatte auf der von der Kontaktfläche abgewandten Seite des Kühlkörpers, insbesondere der Grundplatte und des Tragabschnitts, angeordnet,
wobei eine erste Leiterplatte auf der der Kontaktfläche zugewandten Seite des Kühlkörpers, insbesondere der Grundplatte und des Tragabschnitts, angeordnet ist, wobei die erste Leiterplatte mit pulsweitenmoduliert angesteuerten Bauteilen, insbesondere mit dem pulsweitenmoduliert angesteuerten Leistungsmodul, bestückt ist. Von Vorteil ist dabei, dass der Kühlkörper als Abschirmung fungiert. Somit ist die auf der dritten Leiterplatte angeordnete elektronische Schaltung ungestört von den getaktet betriebenen Bauelementen der ersten Leiterplatte.

Die Erfindung wird nun anhand von schematischen Abbildungen näher erläutert:

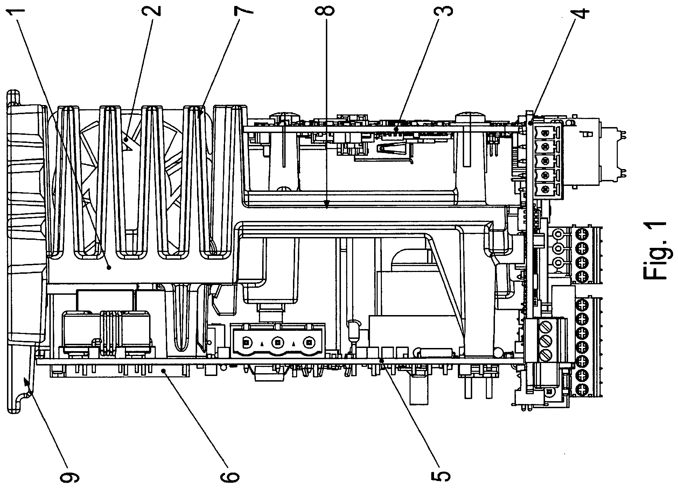

In der Figur 1 ist eine Seitenansicht eines Elektrogeräts bei entferntem Gehäuse gezeigt, wobei Leiterplatten (3, 4, 5) an einem Kühlkörper 1 befestigt sind.

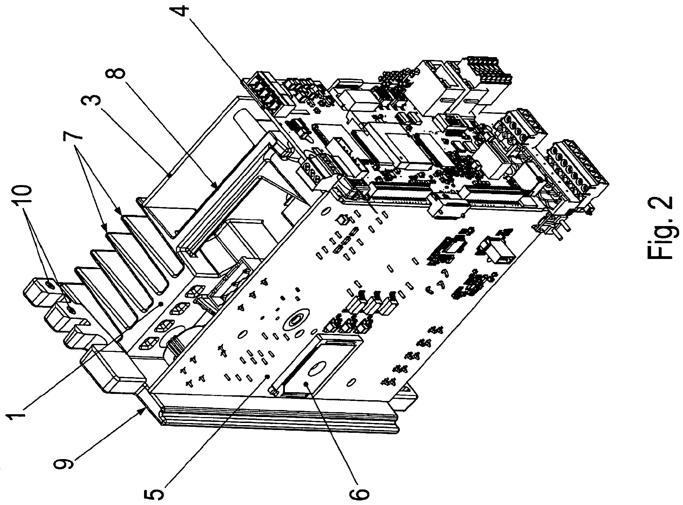

In der Figur 2 ist das Elektrogerät bei entferntem Gehäuse in Schrägansicht gezeigt.

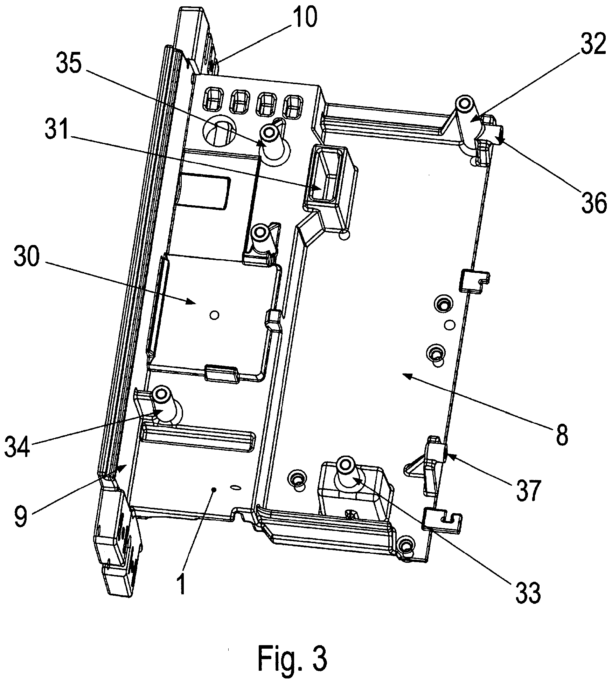

In der Figur 3 ist der Kühlkörper 1 in Schrägansicht aus einer ersten Blickrichtung gezeigt.

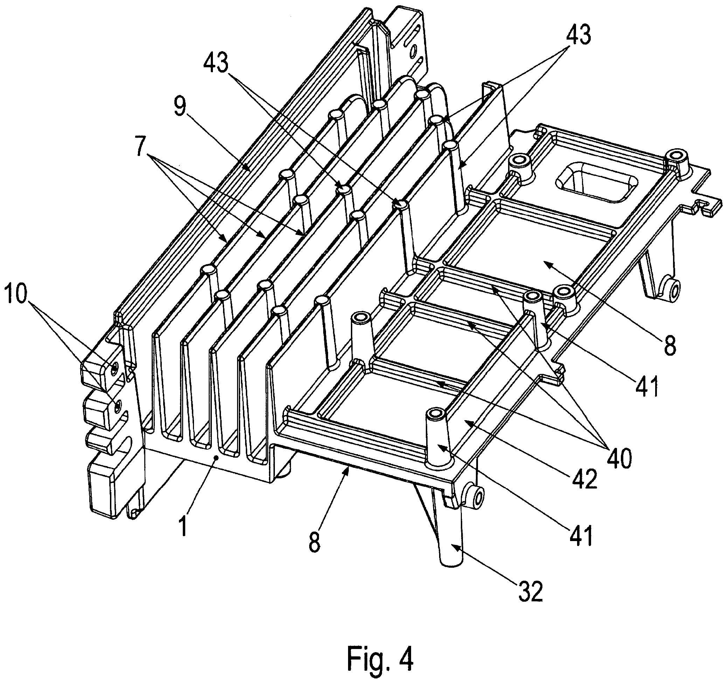

In der Figur 4 ist der Kühlkörper 1 in Schrägansicht aus einer zweiten Blickrichtung gezeigt.

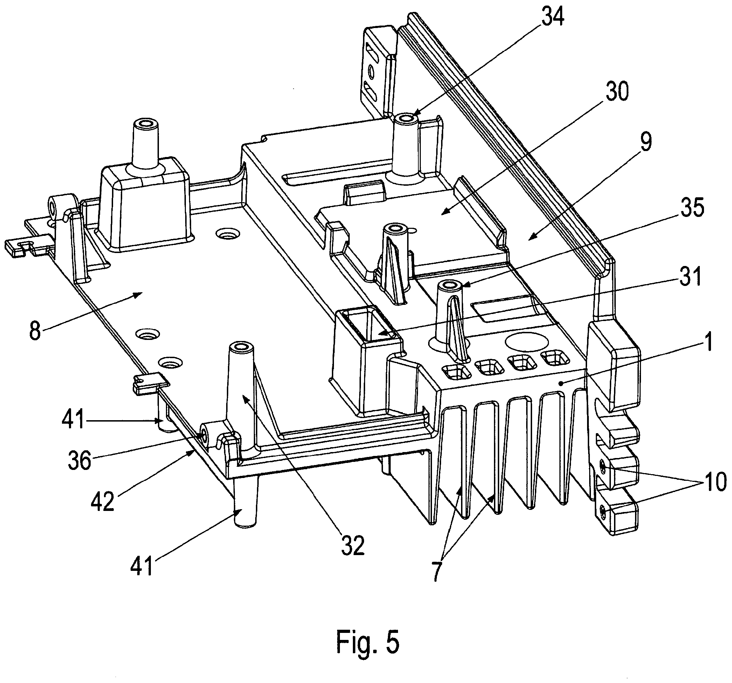

In der Figur 5 ist der Kühlkörper 1 in Schrägansicht aus einer dritten Blickrichtung gezeigt.

Wie in den Figuren dargestellt, weist das Elektrogerät, insbesondere ein zur Speisung eines Elektromotors vorgesehener Umrichter, den Kühlkörper 1 auf, an dessen Seiten die Leiterplatten (3, 4, 5) befestigt sind. Dabei ist eine erste 3 der drei Leiterplatten senkrecht zu einer zweiten 4 der drei Leiterplatten ausgerichtet, wobei die zweite 4 der drei Leiterplatten senkrecht zur dritten 5 der drei Leiterplatten ausgerichtet ist. Dabei ist die erste Leiterplatte 3 parallel zur dritten Leiterplatte 5 ausgerichtet. Die Leiterplatten (3, 4, 5) bilden somit ein unterbrochenes U.

Die dritte Leiterplatte 5 ist bestückt oder elektrisch verbunden mit einem Leistungsmodul 6, welches von einem Federelement gegen eine am Kühlkörper 1 ausgeformte Kontaktfläche 30 gedrückt ist.

Am Kühlkörper 1 ist ein Lüfter angeordnet, wobei der von ihm geförderte Kühlluftstrom entlang von parallel am Kühlkörper 1 ausgeformten Kühlrippen strömt.

Am Kühlkörper 1 sind Domabschnitte (32, 33, 34, 35, 41) ausgeformt, welche seitlich hervorragen. Dabei ist die Dicke der Domabschnitte (32, 33, 34, 35, 41) derart gewählt, dass am äußeren Endberiech des jeweiligen Domabschnitts (32, 33, 34, 35, 41) eine Gewindebohrung eingebracht ist, in welche eine Schraube einschraubbar ist, deren verbreiterter Schraubenkopf eine jeweilige Leiterplatte (2, 4, 5) zum jeweiligen Domabschnitt (32, 33, 34, 35, 41) hindrückt.

Die Domabschnitte (36, 37) ragen dabei an der Vorderseite und die anderen Domabschnitt (32, 33, 34, 35, 41) an den beiden Seiten hervor. Somit erstrecken sich die Domabschnitte (36, 37) senkrecht zu den anderen Domabschnitten (32, 33, 34, 35, 41).

Der Kühlkörper 1 ist einstückig, also einteilig, ausgeführt, wobei die Kühlrippen 7 sich von einer ersten Seite der Grundplatte des Kühlkörpers 1 aus erheben. Die Kühlrippen 7 sind parallel ausgerichtet und vorzugsweise voneinander regelmäßig beabstandet.

Von der anderen Seite der Grundplatte erheben sich die Domabschnitte 35 und 36. Außerdem ist an dieser anderen Seite ein fein bearbeitetes, insbesondere geschliffenes, Oberflächenstück ausgebildet, welches als Kontaktfläche 30 für das Leistungsmodul 6 fungiert. Somit wird im Betrieb des Elektrogeräts ein starker Wärmestrom vom Leistungsmodul 6 in die Grundplatte und von dort in die Kühlrippen 7 eingetragen. Mittels des Lüfters 2, der einen Luftstrom entlang der Kühlrippen 7 fördert, ist eine Entwärmung ermöglicht.

Mittig in der Kontaktfläche 30 ist eine Gewindebohrung in die Grundplatte eingebracht, so dass das Leistungsmodul 6 mittels einer Schraube, welche durch das Leistungsmodul 6 hindurchgeführt ist und in die Gewindebohrung eingeschraubt ist, insbesondere mittels des Schraubenkopfes der Schraube, gegen die Kontaktfläche drückbar ist.

Somit fungiert die Grundplatte als Haltemittel für eine 5 der drei Leiterplatte (3, 4, 5) und für die Kühlrippen 7 sowie für das Leistungsmodul 6.

Parallel zu den Kühlrippen 7, also senkrecht zur Grundplatte, ist ein plattenförmiger Wandabschnitt 9 an der Grundplatte ausgeformt. An diesem Tragabschnitt ist auch ein Anschluss 10 für PE-Verbindung vorgesehen.

Mittels des Wandabschnitts 9 ist das Elektrogerät an einer Hutschiene oder an einer Wand eines Schaltschranks befestigbar. Die Haltekräfte hierzu werden also über den Wandabschnitt 9 eingetragen.

Auch das in den Figuren nicht gezeigte Schutzgehäuse ist befestigt am Kühlkörper 1. Somit sind alle Teile des Elektrogeräts vom Kühlkörper 1 gehalten, der wiederum mittels seines Wandabschnitts 9 an einer Wand oder einer Maschine gehalten wird.

Die Kühlrippen 7 sind nur einseitig an der Grundplatte angeordnet. Der Wandabschnitt 9 umfasst die senkrechte Projektion des gesamten restlichen Kühlkörpers 1 auf den Wandabschnitt 9. Somit ist der Wandabschnitt 9 also weiter ausgedehnt als die senkrechte Projektion, insbesondere wobei der Wandabschnitt 9 hierzu als plattenförmiges, also ebenes Teil, ausgeführt ist.

Wie in den Figuren dargestellt, erstreckt sich der Wandabschnitt 9 beidseitig der Grundplatte des Kühlkörpers 1.

Vorzugsweise ist die Grundplatte im Beriech der Kontaktfläche 30 mit einer größeren Wandstärke ausgeführt, also verdickt ausgeführt. Auf diese Weise ist die Wärmekapazität in dem Bereich der Kontaktfläche 30 erhöht und die einströmende Wärme somit aufspreizbar.

Auf der von den Kühlrippen 7 abgewandten Seite der Grundplatte erheben sich die Domabschnitte 34 und 35. Dabei ist der jeweilige Domabschnitt 35 freistehend ausgeformt.

Der Domabschnitt 34 jedoch ist mittels einer Verbindungswand mit dem Wandabschnitt 9 verbunden, so dass hierbei nicht nur die Stabilität des Kühlkörpers 1 und speziell auch des Domabschnitts 34 verbessert ist, sondern auch die Wärmekapazität vergrößert ist.

Die Grundplatte des Kühlkörpers 1 mündet etwa mittig in den Wandabschnitt 9.

Mit einem Versatz zur Grundplatte ist ein plattenförmiger Tragabschnitt 8 am Kühlkörper 1 ausgeformt. Somit mündet der Tragabschnitt 8 in derjenigen Kühlrippe 7, welche am weitesten von dem Wandabschnitt 9 entfernt angeordnet ist.

An dem Tragabschnitt 8 erheben sich ebenfalls Domabschnitte 32 zur Befestigung der Leiterplatte 5.

An der dem Tragabschnitt 8 zugewandten Seite der Leiterplatte 5 ist diese bestückt mit einem Leistungsbauteil, insbesondere einem steuerbaren Halbleiterschalter, wie Schaltnetzteiltransistor.

Das Leistungsbauteil ist mit einer wärmeleitenden Gummitülle umgeben in eine am Kühlkörper 1 ausgeformte Aufnahmetasche 31 eingesteckt. Somit ist das Leistungsbauteil elektrisch isoliert und wärmeleitend verbunden mit der Aufnahmetasche 31. Statt einer Gummitülle wäre auch ein anderer elektrisch isolierender aber gut wärmeleitender Stoff verwendbar, welcher zwischen der Aufnahmetasche 31 und dem Leistungsbauteil angeordnet ist.

An dem Tragabschnitt 8 ist ein Domabschnitt 32 angeordnet, welcher auf derselben Seite des Tragabschnitts 8 angeordnet ist wie auch die Aufnahmetasche 31.

An diesem Domabschnitt 32 ragt ein weiterer Domabschnitt 36 in Querrichtung hervor, insbesondere also quer zur Normalenrichtung des im Wesentlichen eine Ebene darstellenden Tragabschnitts 8. Sie in den weiteren Domabschnitt 36 eingebrachte Gewindebohrung ist also senkrecht ausgerichtet zu derjenigen Gewindebohrung, welche in den Domabschnitt 32 eingebracht ist.

Da der weitere Domabschnitt 36 seitlich aus dem Domabschnitt 32 herausragt, ist eine hohe Stabilität erreicht. Insbesondere ist hierzu eine hohe Materialdicke vorhanden.

Die Aufnahmetasche 31 ist auf dem Tragabschnitt 8 angeordnet. Dabei ist diese Aufnahmetasche 31 mit Seitenwänden ausgeführt, die sich von dem Tragabschnitt 8 aus erheben. Infolge der Gummitülle ist das Leistungsbauteil spielfrei in der Aufnahmetasche 31 aufgenommen.

Eine der Seitenwände der Aufnahmetasche 31 ist an derjenigen Kühlrippe angeformt, in welche der Tragabschnitt 8 mündet.

Auf der von der Aufnahmetasche 31 abgewandten Seite des Tragabschnitts 8 sind Verstärkungsrippen 40 an dem Tragabschnitt 8 angeformt.

Außerdem erheben sich von dem Tragabschnitt 8 auf dieser Seite zwei voneinander beabstandete Domabschnitte 41, welche mittels einer Verbindungswand 42 verbunden sind, wobei die Verbindungswand 42 sich ebenfalls vom Tragabschnitt 8 aus sich erhebt und ebenfalls wie auch die Domabschnitte 41 einstückig am Tragabschnitt 8 ausgeformt ist.

Die Kühlrippen 7 weisen Verdickungen 43 auf, welche in Erstreckungsrichtung der Kühlrippen 7, insbesondere also in Richtung des zwischen den Kühlrippen strömenden Kühlluftstroms, voneinander regelmäßig beabstandet sind.

Insbesondere weist das Leistungsmodul Leistungsschalter auf, wie IGBT oder MOSFET. Diese Leistungsschalter sind in Halbbrücken angeordnet, welche mit Gleichspannung aus einem netzgespeisten Gleichrichter versorgt werden. Ausgangsseitig wird vom Leistungsmodul ein dreiphasiges Spannungssystem zur Speisung eines Drehstrommotors bereitgestellt. Vorzugsweise werden die Leistungsschalter pulsweitenmoduliert betrieben.

Da der Kühlkörper 1 aus Metall, insbesondere Aluminium, gefertigt ist, fungiert der Tragabschnitt 8 des Kühlkörpers 1 auch als Abschirmung der auf der Leiterplatte 3 angeordneten elektronischen Schaltung gegen das Leistungsmodul und die auf der Leiterplatte 5 angeordnete Ansteuerung des Leistungsmoduls.

Da der Tragabschnitt 8 ununterbrochen ausgeführt ist, ist eine effiziente HF-Abschirmung zwischen den getaktet betriebenen Bauelementen und den auf der anderen Seite des Tragabschnitts 8 angeordneten Bauelementen der Leiterplatte 3 erreichbar.

Vorteiligerweise ist ein einfaches topfförmiges aus Kunststoff gefertigtes Gehäuse von der dem Wandabschnitt 9 gegenüberliegenden Seite des Tragabschnitts 8 herkommend überstülpbar über den Kühlkörper 1 und die daran befestigten Leiterplatten (3, 4, 5). Das Gehäuse ist mittels einer Schraube am Kühlkörper befestigbar, wobei die Schraube in eine Gewindebohrung des Kühlkörpers einschraubbar ist. Alternativ ist auch ein Einrasten des Gehäuses am Wandabschnitt 9 ausführbar.

### Bezugszeichenliste

1 Kühlkörper
2 Lüfter
3 dritte Leiterplatte
4 zweite Leiterplatte
5 erste Leiterplatte
6 Leistungsmodul
7 Kühlrippe
8 Tragabschnitt
9 Wandabschnitt
10 Anschluss für PE-Verbindung
30 Kontaktfläche für Leistungsmodul 6
31 Aufnahmetasche
32 Domabschnitt
33 Domabschnitt
34 Domabschnitt
35 Domabschnitt
36 Domabschnitt
37 Domabschnitt
40 Verstärkungsrippe
41 Domabschnitt
42 Verbindungswand
43 Verdickung

## Patentansprüche

1. **Elektrogeräteanordnung, aufweisend ein a**n einem Tragelement, insbesondere Wand, befestigbares Elektrogerät,
wobei das Elektrogerät einen Kühlkörper (1), Leiterplatten (3, 4, 5) und ein Gehäuse aufweist,
**wobei**
die Leiterplatten (3, 4, 5) jeweils am Kühlkörper (1) befestigt sind und der Kühlkörper (1) an dem Tragelement befestigbar ist oder befestigt ist,
insbesondere wobei das Gehäuse die Leiterplatten (3, 4, 5) gehäusebildend umgibt und am Kühlkörper (1) befestigt ist, wobei der Kühlkörper (1) eine Grundplatte, an der eine Kontaktfläche (30) angeordnet ist, aufweist, wobei am Kühlkörper (1) Kühlrippen (7) an der der Kontaktfläche gegenüberliegenden Seite der Grundplatte ausgeformt sind, wobei an einer ersten der Kühlrippen (7) ein plattenförmiger, parallel zur Grundplatte angeordneter Tragabschnitt (8) angeformt ist,
**wobei am Tragabschnitt (8) eine Aufnahmetasche (31) angeordnet ist, wobei eine Seite der Aufnahmetasche (31) mittels einem Bereich der ersten Kühlrippe (7) gebildet ist,**
**wobei ein Wärme erzeugendes Bauteil, insbesondere Leistungsbauteil, insbesondere Halbleiterschalter, in der Aufnahmetasche (31) angeordnet ist, wobei zwischen dem Bauteil und der Aufnahmetasche (31) ein elektrisch isolierendes, wärmeleitendes Material angeordnet ist.**

2. **Elektrogeräteanordnung** nach Anspruch 1,
**dadurch gekennzeichnet, dass**
das Elektrogerät ein Leistungsmodul (6) aufweist, welches pulsweitenmoduliert angesteuerte Halbleiterschalter aufweist,
insbesondere wobei das Leistungsmodul (6) auf der ersten der Leiterplatten (3, 4, 5) angeordnet ist.

3. **Elektrogeräteanordnung** nach mindestens einem der vorangegangenen Ansprüche,
**dadurch gekennzeichnet, dass**
das Leistungsmodul (6) an einer Kontaktfläche (30) des Kühlkörpers (1) mit dem Kühlkörper (1) verbunden ist, insbesondere zur Wärmeabfuhr.

4. **Elektrogeräteanordnung** nach mindestens einem der vorangegangenen Ansprüche, **dadurch gekennzeichnet, dass**
ein plattenförmiger, senkrecht zur Grundplatte angeordneter Wandabschnitt (9) an der Grundplatte angeformt ist,
wobei die Grundplatte zwischen dem Tragabschnitt (8) und dem Wandabschnitt (9) angeordnet ist,
insbesondere wobei das Elektrogerät mittels des Wandabschnitts (9) an der Wand befestigbar und/oder befestigt ist.

5. **Elektrogeräteanordnung** nach mindestens einem der vorangegangenen Ansprüche, **dadurch gekennzeichnet, dass**
Wandabschnitt (9), Grundplatte, Kühlrippen (7) und Tragabschnitt (8) einstückig, also einteilig, als Kühlkörper (1) ausgebildet sind,
insbesondere als Aluminiumgussteil,
und/oder dass
eine dritte Leiterplatte (3) auf der von der Kontaktfläche (30) abgewandten Seite des Kühlkörpers (1), insbesondere der Grundplatte und des Tragabschnitts, angeordnet ist, wobei eine erste Leiterplatte (5) auf der der Kontaktfläche (30) zugewandten Seite des Kühlkörpers (1), insbesondere der Grundplatte und des Tragabschnitts, angeordnet ist,
wobei die erste Leiterplatte (5) mit pulsweitenmoduliert angesteuerten Bauteilen, insbesondere mit dem pulsweitenmoduliert angesteuerten Leistungsmodul (6), bestückt ist.

6. **Elektrogeräteanordnung** nach mindestens einem der vorangegangenen Ansprüche, **dadurch gekennzeichnet, dass**
der Tragabschnitt (8) einen Versatz zur Grundplatte aufweist,
insbesondere also die Ebene des Tragabschnitts zur Ebene der Grundplatte zwar parallel aber beabstandet ist.

7. **Elektrogeräteanordnung** nach mindestens einem der vorangegangenen Ansprüche,
**dadurch gekennzeichnet, dass**
**die Elastizität des elektrisch isolierenden, wärmeleitenden Materials größer ist als Aluminium und als das Trägermaterial der ersten der Leiterplatten (3, 4, 5) und dessen spezifische Wärmeleitfähigkeit mindestens ein Zehntel von Aluminium beträgt.**

8. **Elektrogeräteanordnung** nach mindestens einem der vorangegangenen Ansprüche,
**dadurch gekennzeichnet, dass**
das Leistungsbauteil in eine wärmeleitende Kunststoffhülle, insbesondere Gummitülle, eingeführt und mit dieser in der Aufnahmetasche (31) spielfrei aufgenommen ist.

9. **Elektrogeräteanordnung** nach mindestens einem der vorangegangenen Ansprüche,
**dadurch gekennzeichnet, dass**
am Wandabschnitt (9) des Kühlkörpers (1) ein Anschluss (10) für PE-Verbindung, insbesondere also Verbindung mit elektrisch Erde, angeordnet ist.

10. **Elektrogeräteanordnung** nach mindestens einem der vorangegangenen Ansprüche,
**dadurch gekennzeichnet, dass**
am Tragabschnitt (8) beidseitig Domabschnitte und an der den Kühlkörpern gegenüberliegenden Seite der Grundplatte ebenfalls Domabschnitte ausgeformt sind,
wobei eine erste Leiterplatte (5) an ersten Domabschnitten, insbesondere mittels Schrauben,
wobei die ersten Domabschnitte (32) sich von dem Tragabschnitt (8) aus erheben, und an zweiten Domabschnitten (35) befestigt ist, wobei die zweiten Domabschnitte (35) sich von der den Kühlrippen (7) gegenüberliegenden Seite der Grundplatte aus erheben,
wobei eine dritte Leiterplatte (3) an dritten Domabschnitten (41), insbesondere mittels Schrauben, befestigt ist, wobei die dritten Domabschnitte (41) sich von der der ersten Leiterplatte (5) gegenüberliegenden Seite des Tragabschnitts aus erheben,
wobei eine zweite Leiterplatte (4) an vierten Domabschnitten befestigt ist, wobei einer (36) der vierten Domabschnitte sich von einem (32) der ersten Domabschnitte aus erhebt, also angeformt ist an den ersten Domabschnitt (32),
wobei die erste Leiterplatte (5) parallel zur dritten Leiterplatte (3) ausgerichtet ist,
wobei die erste Leiterplatte (5) zur dritten Leiterplatte (3) beabstandet ist,
insbesondere wobei der Tragabschnitt (8) zwischen der ersten und dritten Leiterplatte (3, 5) angeordnet ist,
wobei die zweite Leiterplatte (4) senkrecht zur ersten und auch senkrecht zur dritten Leiterplatte (3) angeordnet ist.

11. **Elektrogeräteanordnung** nach mindestens einem der vorangegangenen Ansprüche,
**dadurch gekennzeichnet, dass**
zur Befestigung der jeweiligen Leiterplatte (3, 4, 5) am jeweiligen Domabschnitt im dem jeweiligen Domabschnitt eine Gewindebohrung angeordnet ist,
wobei ein Schraubenkopf einer jeweiligen in die jeweilige Gewindebohrung eingeschraubten Schraube die jeweilige Leiterplatte (3, 4, 5) gegen den jeweiligen Domabschnitt drückt.

12. **Elektrogeräteanordnung** nach mindestens einem der vorangegangenen Ansprüche,
**dadurch gekennzeichnet, dass**
der Tragabschnitt (8) an seiner von der ersten Leiterplatte (5) abgewandten Seite Verstärkungsrippen (40) aufweist,
insbesondere gitterförmig ausgeführte Verstärkungsrippen (40).

13. **Elektrogeräteanordnung** nach mindestens einem der vorangegangenen Ansprüche,
**dadurch gekennzeichnet, dass**
jede der Kühlrippen (7) Verdickungen (43), insbesondere regelmäßig voneinander beabstandete Verdickungen (43), aufweist.

## Claims

1. Electrical device assembly comprising an electrical device that can be fastened to a supporting element, in particular a wall,
wherein the electrical device comprises a cooling member (1), printed circuit boards (3, 4, 5) and a housing,
wherein the printed circuit boards (3, 4, 5) are each fastened to the cooling member (1), and the cooling member (1) is fastenable or fastened to the supporting element,
in particular wherein the housing encloses the printed circuit boards (3, 4, 5) in a manner forming a housing and is fastened to the cooling member (1), wherein the cooling member (1) has a base plate on which a contact surface (30) is arranged, wherein cooling ribs (7) are shaped on the cooling member (1) on the opposite side of the base plate from the contact surface, wherein a plate-like supporting portion (8) arranged in parallel with the base plate is formed on a first of the cooling ribs (7),
wherein a receiving recess (31) is arranged in the supporting portion (8), wherein one side of the receiving recess (31) is formed by means of a region of the first cooling rib (7), wherein a heat-generating component, in particular a power component, in particular a semiconductor switch, is arranged in the receiving recess (31), wherein an electrically insulating, heat-conducting material is arranged between the component and the receiving recess (31).

2. Electrical device assembly according to claim 1,
**characterised in that**
the electrical device has a power module (6), which has semiconductor switches that are actuated in a pulse-width-modulated manner,
in particular wherein the power module (6) is arranged on the first of the printed circuit boards (3, 4, 5).

3. Electrical device assembly according to at least one of the preceding claims,
**characterised in that**
the power module (6) is connected to the cooling member (1) on a contact surface (30) of the cooling member (1), in particular for the purpose of dissipating heat.

4. Electrical device assembly according to at least one of the preceding claims,
**characterised in that**
a plate-like wall portion (9) arranged perpendicularly to the base plate is formed on the base plate,
wherein the base plate is arranged between the supporting portion (8) and the wall portion (9),
in particular wherein the electrical device is fastenable and/or fastened to the wall by means of the wall portion (9).

5. Electrical device assembly according to at least one of the preceding claims,
**characterised in that**
the wall portion (9), base plate, cooling ribs (7) and supporting portion (8) are formed as the cooling member (1) in one piece, i.e. as a single part,
in particular as an aluminium cast part,
and/or **in that**
a third printed circuit board (3) is arranged on the side of the cooling member (1), in particular of the base plate and supporting portion, that faces away from the contact surface (30),
wherein a first printed circuit board (5) is arranged on the side of the cooling member (1), in particular of the base plate and supporting portion, that faces the contact surface (30), wherein the first printed circuit board (5) is fitted with components that are actuated in a pulse-width-modulated manner, in particular with the power module (6) actuated in a pulse-width-modulated manner.

6. Electrical device assembly according to at least one of the preceding claims,
**characterised in that**
the supporting portion (8) has an offset from the base plate,
the plane of the supporting portion thus in particular being parallel to the plane of the base plate but at a distance therefrom.

7. Electrical device assembly according to at least one of the preceding claims,
**characterised in that**
the resilience of the electrically insulating, heat-conducting material is greater than that of aluminium and of the substrate material of the first of the printed circuit boards (3, 4, 5), and its specific thermal conductivity is at least a tenth of that of aluminium.

8. Electrical device assembly according to at least one of the preceding claims,
**characterised in that**
the power component is inserted into a heat-conducting plastics jacket, in particular a rubber sleeve, and is received together therewith in the receiving recess (31) without play.

9. Electrical device assembly according to at least one of the preceding claims,
**characterised in that**
a terminal (10) for a PE connection, in particular therefore a connection to electrical earth, is arranged on the wall portion (9) of the cooling member (1).

10. Electrical device assembly according to at least one of the preceding claims,
**characterised in that**
dome portions are shaped on both sides on the supporting portion (8), and dome portions are likewise shaped on the opposite side of the base plate from the cooling members,
wherein a first printed circuit board (5) is fastened to first dome portions, in particular by means of screws, the first dome portions (32) projecting out from the supporting portion (8), and fastened to second dome portions (35), the second dome portions (35) projecting out from the opposite side of the base plate from the cooling ribs (7),
wherein a third printed circuit board (3) is fastened to third dome portions (41), in particular by means of screws, the third dome portions (41) projecting out from the opposite side of the supporting portion from the first printed circuit board (5),
wherein a second printed circuit board (4) is fastened to fourth dome portions, one (36) of the fourth dome portions projecting out from one (32) of the first dome portions, i.e. being formed on the first dome portion (32),
wherein the first printed circuit board (5) is oriented in parallel with the third printed circuit board (3),
wherein the first printed circuit board (5) is at a distance from the third printed circuit board (3),
in particular wherein the supporting portion (8) is arranged between the first and third printed circuit boards (3, 5),
wherein the second printed circuit board (4) is arranged perpendicularly to the first printed circuit board and perpendicularly to the third printed circuit board (3).

11. Electrical device assembly according to at least one of the preceding claims,
**characterised in that**
to fasten each printed circuit board (3, 4, 5) to the relevant dome portion, a threaded bore is arranged in each dome portion,
wherein a screw head of a respective screw screwed into each threaded bore presses the particular printed circuit board (3, 4, 5) against the particular dome portion.

12. Electrical device assembly according to at least one of the preceding claims,
**characterised in that**
the supporting portion (8) has reinforcement ribs (40) on its side facing away from the first printed circuit board (5),
in particular reinforcement ribs (40) configured in a grid pattern.

13. Electrical device assembly according to at least one of the preceding claims,
**characterised in that**
each of the cooling ribs (7) has thickened portions (43), in particular thickened portions (43) arranged at a regular distance from one another.

## Revendications

1. Agencement d'appareil électrique, présentant un appareil électrique pouvant être fixé sur un élément porteur, en particulier un mur,
l'appareil électrique présentant un dissipateur thermique (1), des cartes de circuit imprimé (3, 4, 5) et un boîtier,
les cartes de circuit imprimé (3, 4, 5) étant fixées chacune sur le dissipateur thermique (1) et le dissipateur thermique (1) pouvant être fixé ou étant fixé sur l'élément porteur, en particulier le boîtier entourant les cartes de circuit imprimé (3, 4, 5) de façon à former un boîtier et étant fixé au dissipateur thermique (1),
le dissipateur thermique (1) présentant une plaque de base sur laquelle est disposée une surface de contact (30), des ailettes de refroidissement (7) étant formées sur le dissipateur thermique (1) sur le côté de la plaque de base opposé à la surface de contact, une partie de support (8) en forme de plaque, disposée parallèlement à la plaque de base, étant formée sur une première des ailettes de refroidissement (7),
une poche de réception (31) étant disposée sur la partie de support (8), un côté de la poche de réception (31) étant formé au moyen d'une zone de la première ailette de refroidissement (7),
un composant produisant de la chaleur, en particulier un composant de puissance, en particulier un commutateur à semi-conducteurs, étant disposé dans la poche de réception (31), un matériau électriquement isolant et thermiquement conducteur étant disposé entre le composant et la poche de réception (31).

2. Agencement d'appareil électrique selon la revendication 1,
**caractérisé en ce**
**que** l'appareil électrique présente un module de puissance (6) qui présente des commutateurs à semi-conducteurs commandés par modulation de largeur d'impulsion, en particulier le module de puissance (6) étant disposé sur la première des cartes de circuit imprimé (3, 4, 5).

3. Agencement d'appareil électrique selon au moins l'une des revendications précédentes,
**caractérisé en ce**
**que** le module de puissance (6) est relié au dissipateur thermique (1) par une surface de contact (30) du dissipateur thermique (1), en particulier pour la dissipation de chaleur.

4. Agencement d'appareil électrique selon au moins l'une des revendications précédentes,
**caractérisé en ce**
**qu'**une partie formant paroi (9) en forme de plaque, disposée perpendiculairement à la plaque de base, est formée sur la plaque de base,
la plaque de base étant disposée entre la partie de support (8) et la partie formant paroi (9),
en particulier l'appareil électrique pouvant être fixé et/ou étant fixé au mur au moyen de la partie formant paroi (9).

5. Agencement d'appareil électrique selon au moins l'une des revendications précédentes,
**caractérisé en ce**
**que** la partie formant paroi (9), la plaque de base, les ailettes de refroidissement (7) et la partie de support (8) sont réalisées d'un seul tenant, c'est-à-dire d'une seule pièce, en tant que dissipateur thermique (1), en particulier sous la forme d'une pièce coulée en aluminium, et/ou en ce
**qu'**une troisième carte de circuit imprimé (3) est disposée sur le côté du dissipateur thermique (1), en particulier de la plaque de base et de la partie de support, qui est opposé à la surface de contact (30), une première carte de circuit imprimé (5) étant disposée sur le côté du dissipateur thermique (1), en particulier de la plaque de base et de la partie de support, qui est tourné vers la surface de contact (30), la première carte de circuit imprimé (5) étant équipée de composants commandés par modulation de largeur d'impulsions, en particulier du module de puissance (6) commandé par modulation de largeur d'impulsions.

6. Agencement d'appareil électrique selon au moins l'une des revendications précédentes,
**caractérisé en ce**
**que** la partie de support (8) présente un décalage par rapport à la plaque de base,
en particulier que le plan de la partie de support est parallèle au plan de la plaque de base, mais espacé de celui-ci.

7. Agencement d'appareil électrique selon au moins l'une des revendications précédentes,
**caractérisé en ce**
**que** l'élasticité du matériau électriquement isolant et thermiquement conducteur est supérieure à celle de l'aluminium et à celle du matériau de support de la première des cartes de circuit imprimé (3, 4, 5) et que sa conductivité thermique spécifique est d'au moins un dixième de celle de l'aluminium.

8. Agencement d'appareil électrique selon au moins l'une des revendications précédentes,
**caractérisé en ce**
**que** le composant de puissance est introduit dans une douille en matière plastique conductrice de la chaleur, en particulier une douille en caoutchouc, et est reçu sans jeu avec celle-ci dans la poche de réception (31).

9. Agencement d'appareil électrique selon au moins l'une des revendications précédentes,
**caractérisé en ce**
**que** sur la partie formant paroi (9) du dissipateur thermique (1) est disposé un raccord (10) pour une liaison PE, en particulier donc une liaison avec la terre électrique.

10. Agencement d'appareil électrique selon au moins l'une des revendications précédentes,
**caractérisé en ce**
**que** des parties en dôme sont formées des deux côtés sur la partie de support (8) et des parties en dôme sont également formées sur le côté de la plaque de base opposé aux dissipateurs thermiques,
une première carte de circuit imprimé (5) étant fixée à des premières parties en dôme, en particulier au moyen de vis,
les premières parties en dôme (32) s'élevant à partir de la partie de support (8) et étant fixées à des deuxièmes parties en dôme (35), les deuxièmes parties en dôme (35) s'élevant à partir du côté de la plaque de base opposé aux ailettes de refroidissement (7),
une troisième carte de circuit imprimé (3) étant fixée à des troisièmes parties en dôme (41), en particulier au moyen de vis, les troisièmes parties en dôme (41) s'élevant à partir du côté de la partie de support opposé à la première carte de circuit imprimé (5), une deuxième carte de circuit imprimé (4) étant fixée à des quatrièmes parties en dôme, l'une (36) des quatrièmes parties en dôme s'élevant à partir de l'une (32) des premières parties en dôme, c'est-à-dire étant formée sur la première partie en dôme (32),
la première carte de circuit imprimé (5) étant orientée parallèlement à la troisième carte de circuit imprimé (3),
la première carte de circuit imprimé (5) étant espacée de la troisième carte de circuit imprimé (3),
en particulier la partie de support (8) étant disposée entre la première et la troisième carte de circuit imprimé (3, 5),
la deuxième carte de circuit imprimé (4) étant disposée perpendiculairement à la première et également perpendiculairement à la troisième carte de circuit imprimé (3).

11. Agencement d'appareil électrique selon au moins l'une des revendications précédentes,
**caractérisé en ce**
**que**, pour la fixation de la carte de circuit imprimé respective (3, 4, 5) sur la partie en dôme respective, un trou taraudé est disposé dans la partie en dôme respective,
une tête de vis d'une vis respective vissée dans le trou taraudé respectif pressant la carte de circuit imprimé respective (3, 4, 5) contre la partie en dôme respective.

12. Agencement d'appareil électrique selon au moins l'une des revendications précédentes,
**caractérisé en ce**
**que** la partie de support (8) présente des nervures de renforcement (40) sur son côté opposé à la première carte de circuit imprimé (5), en particulier des nervures de renforcement (40) réalisées en forme de grille.

13. Agencement d'appareil électrique selon au moins l'une des revendications précédentes,
**caractérisé en ce**
**que** chacune des ailettes de refroidissement (7) présente des surépaisseurs (43), en particulier des surépaisseurs (43) régulièrement espacées les unes des autres.
